(19) Europäisches Patentamt / European Patent Office / Office européen des brevets

(11) **EP 3 199 660 A1**

(12) **EUROPEAN PATENT APPLICATION**
published in accordance with Art. 153(4) EPC

(43) Date of publication:
**02.08.2017 Bulletin 2017/31**

(21) Application number: **15845389.4**

(22) Date of filing: **15.09.2015**

(51) Int Cl.:
*C23C 14/06* (2006.01)      *B21D 37/01* (2006.01)
*B21D 37/20* (2006.01)

(86) International application number:
**PCT/JP2015/076204**

(87) International publication number:
**WO 2016/047508 (31.03.2016 Gazette 2016/13)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **24.09.2014 JP 2014193885**
**26.12.2014 JP 2014266487**

(71) Applicant: **Kabushiki Kaisha Kobe Seiko Sho (Kobe Steel, Ltd.)**
**Kobe-shi, Hyogo 651-8585 (JP)**

(72) Inventor: **YAMAMOTO Kenji**
**Kobe-shi, Hyogo 651-2271 (JP)**

(74) Representative: **Müller-Boré & Partner Patentanwälte PartG mbB**
**Friedenheimer Brücke 21**
**80639 München (DE)**

(54) **LAMINATED HARD COATING AND MOLDING DIE**

(57)      A laminated hard coating obtained by alternately laminating layers (A) and layers (B), which have different compositions, wherein layers (A) comprise $(Ti_aCr_bAl_cSi_d)(C_xN_{1-x})$, layers (B) comprise $(Cr_eSi_{1-e})(C_yN_{1-y})$ or $(Al_fSi_{1-f})(C_zN_{1-z})$, and each of layers (A) and layers (B) has a thickness of 2-100 nm.

EP 3 199 660 A1

**Description**

TECHNICAL FIELD

The present invention relates to a laminated hard film exerting excellent wear resistance and toughness, and a molding die including the above laminated hard film on/above a substrate surface.

BACKGROUND ART

A substrate surface has hitherto been coated with a hard film of TiN, TiCN, TiAlN or the like for the purpose of improving wear resistance of a jig and tool having a cemented carbide, a cermet, a high-speed tool steel, an alloy tool steel or the like as a substrate. However, with an increase in hardness of workpiece materials or an increase in cutting speed, it has been demanded to realize a hard film further increased in wear resistance.

The present inventors have proposed a hard film formed by laminating film layers satisfying predetermined composition ratios on/above a substrate surface of a die for forming a steel material represented by high-tensile steel, for example, as shown in Patent Literature 1.

Through the development of the above technique, it has become possible to realize the hard film more excellent in wear resistance and oxidation resistance than a hard film formed of a monolayer of TiN, TiCN, TiAlN or the like, which has hitherto been used. However, it has been desired to realize a hard film increased in toughness and further improved in durability.

PRIOR ART LITERATURE

PATENT LITERATURE

Patent Literature 1: Japanese Patent No. 4668214

SUNNARY OF THE INVENTION

PROBLEMS TO BE SOLVED BY THE INVENTION

The present invention has been made in view of the circumstances as described above, and an object thereof is to provide: a laminated hard film further improved in wear resistance and toughness; and a molding die.

MEANS FOR SOLVING THE PROBLEMS

The laminated hard film which could solve the above problem(s) is a laminated hard film obtained by laminating a layer A and a layer B, the layer A having a composition different from that of the layer B, wherein
the layer A is formed of $(Ti_aCr_bAl_cSi_d)(C_xN_{1-x})$ and satisfies the relationship of $0 \leq a \leq 0.10$, $0.10 \leq b \leq 0.50$, $0.50 \leq c \leq 0.90$, $0 \leq d \leq 0.05$, $a+b+c+d=1$ and $0 \leq x \leq 0.5$, when atomic ratios of Ti, Cr, Al, Si and C are defined as a, b, c, d and x, respectively,
the layer B is formed of $(Cr_eSi_{1-e})(C_yN_{1-y})$ and satisfies the relationship of $0.90 \leq e \leq 1.0$ and $0 \leq y \leq 0.5$, when atomic ratios of Cr and C are defined as e and y, respectively, or is formed of $(Al_fSi_{1-f})(C_zN_{1-z})$ and satisfies the relationship of $0.90 \leq f \leq 1.0$ and $0 \leq z \leq 0.5$, when atomic ratios of Al and C are defined as f and z, respectively, and
each of the layer A and the layer B has a thickness of 2 to 100 nm, and the layer A and the layer B are each alternately laminated.

It is preferred that the atomic ratio of Al to a total of Ti, Cr, Al and Si in the layer A and the layer B falls within a range of 0.20 to 0.60.

In the laminated hard film of the present invention, it is also preferable that Ti in the layer A is at least partially substituted with Zr.

The molding die further improved in wear resistance and toughness can be realized by including the laminated hard film as described above on/above a substrate surface. In the above molding die, a molding die including an intermediate layer of CrN having a thickness of 3 to 10 μm between the above laminated hard film and the above substrate is also preferred. Further, such a molding die exerts excellent properties, not only at room temperature, but also at a high temperature of about 400 to 500°C, so that it is particularly useful as a die to be used for hot forming of a steel material.

ADVANTAGEOUS EFFECTS OF THE INVENTION

In the present invention, the wear resistance and toughness can be more improved than the conventional monolayer hard film by using a laminated hard film in which layer(s) A showing good wear resistance and layer(s) B showing high toughness are alternately laminated.

## MODES FOR CARRYING OUT THE INVENTION

The hard film of the present invention is a laminated hard film in which layer(s) A showing good wear resistance and layer(s) B showing high toughness are alternately laminated.

The layer(s) A constituting the laminated hard film are formed of $(Ti_aCr_bAl_cSi_d)(C_xN_{1-x})$ and satisfy the following relationship, when the atomic ratios of Ti, Cr, Al, Si and C are defined as a, b, c, d and x, respectively.

$$0{\leq}a{\leq}0.10,\ 0.10{\leq}b{\leq}0.50,\ 0.50{\leq}c{\leq}0.90,\ 0{\leq}d{\leq}0.05,\ a+b+c+d=1,\ 0{\leq}x{\leq}0.5$$

The above layer(s) A contain a predetermined amount of Al, thereby exerting wear resistance excellent in sliding properties with a steel material, particularly in a hot forming region where the temperature becomes high, during forming of the steel material on a surface of which scales have been formed. In order to allow such properties to be exerted, the atomic ratio of Al is 0.50 or more, that is, the value of c is necessary to be 0.50 or more, when the total of the atomic ratios of metal elements of Ti, Cr, Al and Si in the layer(s) A indicated by $(Ti_aCr_bAl_cSi_d)(C_xN_{1-x})$ is a+b+c+d=1. The value of c is preferably 0.60 or more, and more preferably 0.65 or more.

However, when the Al amount is excessive, the wear resistance and the toughness are deteriorated. Therefore, the atomic ratio of Al or the value of c is necessary to be 0.90 or less. The value of c is preferably 0.85 or less, and more preferably 0.80 or less.

Ti in the above layer(s) A may not be contained in the film. However, by allowing Ti to be contained, the hardness of the film is increased to further improve the wear resistance. From such a viewpoint, the atomic ratio of Ti or the value of a is preferably 0.01 or more, and more preferably 0.02 or more. However, when the Ti amount is excessive, the oxidation resistance of the layer(s) A is decreased, particularly during hot forming. Therefore, the atomic ratio of Ti or the value of a is necessary to be 0.10 or less. The value of a is preferably 0.08 or less, and more preferably 0.05 or less.

Cr in the above layer(s) A increases the hardness of the film to improve the wear resistance. From such a viewpoint, the atomic ratio of Cr or the value of b is necessary to be 0.10 or more. The value of b is preferably 0.15 or more, and more preferably 0.20 or more. However, when the Cr amount is excessive, the oxidation resistance of the layer(s) A is decreased. Therefore, the atomic ratio of Cr or the value of b is necessary to be 0.50 or less. The value of b is preferably 0.45 or less, and more preferably 0.40 or less.

A metal element other than Ti, Cr and Al in the above layer(s) A is Si. Si is an element effective for increasing the hardness of the film to improve the wear resistance, and is contained as needed. From such a viewpoint, the atomic ratio of Si or the value of d is preferably 0.01 or more, and more preferably 0.02 or more. However, when the Si amount is excessive, the oxidation resistance of the layers A is decreased. Therefore, the atomic ratio of Si or the value of d is necessary to be 0.05 or less. The value of d is preferably 0.04 or less, and more preferably 0.03 or less.

The above layer(s) A are basically based on a nitride. That is, the layer(s) A indicated by $(Ti_aCr_bAl_cSi_d)(C_xN_{1-x})$ are a nitride in the case of x=0. However, carbon C is sometimes contained as an impurity in the film, and in this case, a carbide is partially formed. However, when the C amount is excessive to increase the carbide amount, the wear resistance of the layer(s) A is decreased. From such a viewpoint, the atomic ratio of C or the value of x is necessary to be 0.5 or less. The value of x is preferably 0.3 or less, and more preferably 0.1 or less.

On the other hand, the layer(s) B constituting the laminated hard film of the present invention are formed of $(Cr_eSi_{1-e})(C_yN_{1-y})$ and satisfy the following relationship, when the atomic ratios of Cr and C are defined as e and y, respectively,

$$0.90{\leq}e{\leq}1.0,\ 0{\leq}y{\leq}0.5$$

or formed of $(Al_fSi_{1-f})(C_zN_{1-z})$ and satisfy the following relationship, when the atomic ratios of Al and C are defined as f and z, respectively.

$$0.90{\leq}f{\leq}1.0,\ 0{\leq}z{\leq}0.5$$

The above layer(s) B contain Cr or Al as a metal element, so that the layer(s) B show high toughness. Specifically, the layer(s) B exert such a property that chipping of the film is less likely to occur under high load. In order to allow the property to be exerted, the atomic ratios of Cr and Al or the values of e and f are both necessary to be 0.90 or more. The values of e and f are both preferably 0.93 or more, and more preferably 0.95 or more.

Although the above layer(s) B may be formed of only Cr or Al, Cr or Al may be partially substituted with Si. Si is an element effective for increasing the hardness of the film to improve the wear resistance, and is contained as needed. However, when the Si amount is excessive, the content of Cr or Al is relatively insufficient, resulting in a decrease in the toughness of the layer(s) B and a decrease in the hardness to cause a decrease in the wear resistance. Therefore, the atomic ratio of Si or the value of 1-e or 1-f is necessary to be 0.10 or less. The value of 1-e or 1-f is preferably 0.07 or less, and more preferably 0.05 or less.

As with the above layer(s) A, the above layer(s) B are basically based on a nitride. That is, the layer(s) B indicated by $(Cr_eSi_{1-e})(C_yN_{1-y})$ or $(Al_fSi_{1-f})(C_zN_{1-z})$ are a nitride in the case of y=0 or z=0. However, carbon C is sometimes contained as an impurity in the film, and in this case, a carbide is partially formed. However, when the C amount is excessive to increase the carbide amount, the toughness of the layer(s) B is decreased. From such a viewpoint, the atomic ratio of C or the value of y or z is necessary to be 0.5 or less. The value of y or z is preferably 0.3 or less, and more preferably 0.1 or less.

As described above, the hard film having both the excellent wear resistance and toughness can be realized by alternately laminating the layer(s) A excellent in the wear resistance and the layer(s) B excellent in the toughness. In order to allow the function of each of the above layer(s) A and layer(s) B to be effectively exerted, the layer(s) A and the layer(s) B are necessary to be alternately laminated as independent layer(s), not in a state where compositions of the layer(s) A and the layer(s) B are mixed. From such a viewpoint, the thickness of each of the layer(s) A and the layer(s) B is necessary to be 2 nm or more. The thickness of each of the layer(s) A and the layer(s) B is preferably 5 nm or more, and more preferably 10 nm or more.

However, an excessive increase in the thickness of each of the layer(s) A and the layer(s) B causes deterioration of properties, particularly the wear resistance, when laminated. From such a viewpoint, the thickness of each of the layer(s) A and the layer(s) B is necessary to be 100 nm or less. The thickness of each of the layer(s) A and the layer(s) B is preferably 50 nm or less, more preferably 40 nm or less, still more preferably 30 nm or less, and particularly preferably 20 nm or less.

The thickness of the layer A and that of the layer B are not necessarily the same with each other. For example, the thickness of the layer A is 20 nm, and the thickness of the layer B may be changed between 2 to 100 nm. Further, the layer(s) B are not necessarily disposed on the substrate side, and the layer(s) A may be present on the substrate side. Furthermore, a film structure that the layer(s) A or the layer(s) B which are present on the substrate side are present on the uppermost surface side may be used, and various laminated structures may be adopted depending on the purpose. In addition, such a structure that CrSiCN and AlSiCN are used as the layer(s) B and laminated on the layer(s) A, specifically "layer A / B1(CrSiCN) / layer A / layer B (AlSiCN) / layer A ⋯", may also be adopted,

The thickness of the whole laminated hard film or the total thickness is not limited in any way. However, in order to allow the properties of the present invention to be effectively exerted, the total thickness of the film is preferably 1 μm (1,000 nm) or more, and more preferably 2 μm (2,000 nm) or more. However, an excessive increase in the total thickness of the film causes deterioration of the toughness of the film. Therefore, it is preferably 20 μm (20,000 nm) or less, more preferably 10 μm (10,000 nm) or less, and still more preferably 8 μm (8,000 nm) or less. The number of times of laminating of the layers A and the layers B is recommended to be properly controlled so as to satisfy the preferred total thickness described above.

Also, in order to maximize the functions of both layers A and B in the laminated state, the number of times of laminating is preferably plural, i.e. 2 or more. From such a viewpoint, it is preferred to make the thickness of each of the layer(s) A and the layer(s) B as thin as possible and to make the number of times of laminating plural. The number of times of laminating as used herein is the value determined, when defining the laminating of the layer A and the layer B as that the number of times of laminating is 1.

The ratios of the elements in each layer of the layer(s) A and the layer(s) B are as described above. However, in the present invention, it has been found that the atomic ratio of Al to the total of the metal elements in the layer(s) A and the layer(s) B, that is, the total of Ti, Cr, Al and Si in the layer(s) A and the layer(s) B, has a large influence on the wear resistance. The term "the atomic ratio of Al to the total of Ti, Cr, Al and Si in the layer(s) A and the layer(s) B" is hereinafter sometimes referred to as "the total Al atomic ratio". As a result of further studies made by the present inventors, it has been found that it is preferred that the above total Al atomic ratio falls within a range of 0.20 to 0.60, in order to ensure the more excellent wear resistance. As the lower limit of the above total Al atomic ratio, it is more preferably 0.30 or more, still more preferably 0.35 or more, and yet still more preferably 0.40 or more. Also, as the upper limit of the above total Al atomic ratio, it is more preferably 0.55 or less.

The above total Al atomic ratio can be calculated in the following manner. The laminated hard film of the present invention is described, taking a combination of the following layer A1 and layer B1 as an example.

Composition of Layer A1: $(Cr_{1-c}Al_c)N$, thickness of layer A1: q nm, that is, a=0, d=0, b=1-c and x=0 in the specified composition
Composition of Layer B1: CrN, thickness of layer B1: r nm, that is, e=1 and y=0 in the specified composition

In this case, the layer A1 and the layer B1 have the same crystal structure.

The lattice constant of the layer A1 can be determined as $\alpha=0.412+0.02\times c$ nm, and the lattice constant of the layer B1 can be determined as $\beta=0.414$ nm. The respective atomic numbers of Al and Cr contained in respective unit volumes of the layer A1 and the layer B1 are determined from the following formulas. The following formulas are determined from the crystal structure.

$$\text{Al Atomic Number in Layer A1} = (1/\alpha)^3 \times 4 \times c$$

$$\text{Cr Atomic Number in Layer A1} = (1/\alpha)^3 \times 4 \times (1-c)$$

$$\text{Cr Atomic Number in Layer B1} = (1/\alpha)^3 \times 4$$

Then, the atomic ratio of Al to the total of Cr and Al in the above layer A1 and layer B1 can be determined by multiplying each atomic number by the thickness of each layer, as shown below.

$$\text{Atomic Ratio of Al to Total of Cr and Al in Layer A1 and Layer B1} =$$

$$(1/\alpha)^3 \times 4 \times c \times q/[(1/\alpha)^3 \times 4 \times c \times q + (1/\alpha)^3 \times 4 \times (1-c) \times q + (1/\beta)^3 \times 4 \times r]$$

In the above example, the combination of CrAlN as the layer A and CrN as the layer B is used. However, even in any combination of the layer A and the layer B specified in the present invention, the total Al atomic ratio can be determined by performing calculation as described above. When the crystal structure is unknown, the calculation as described above cannot be performed. Therefore, the formed layer A or layer B is subjected to measurement by EDX, and the total Al atomic ratio may be determined using the measured results.

In the above layer(s) A, it is also effective that Ti in the layer(s) A is at least partially substituted with Zr, thereby further improving the wear resistance of the layer(s) A. Such an effect is increased as the amount of Zr to be substituted increases. This is because the film components are oxidized by heat generation during sliding in the case of use as a molding die to form a hard oxide film containing Zr on a surface thereof.

Although the ratio of Ti to be substituted with Zr is not particularly limited, it is preferably at least 10% or more to the Ti amount. All of the Ti amount may be substituted with Zr. The preferred atomic ratio range of Zr in this case is the same as the range of the above a in the case where Zr is not allowed to be contained and only Ti is allowed to be contained. That is, when Zr is allowed to be contained in place of Ti, the atomic ratio of Zr is preferably 0.01 or more, and more preferably 0.02 or more, to the whole metal elements of the layer(s) A. However, when the Zr amount is excessive, the oxidation resistance of the layer(s) A is decreased, particularly during hot forming. Therefore, the atomic ratio of Zr is preferably 0.10 or less, more preferably 0.08 or less, and still more preferably 0.05 or less.

The molding die further excellent in the wear resistance and the toughness can be realized by providing the laminated hard film as described above on/above the substrate surface. Further, the molding die of the present invention exerts the excellent properties, particularly also at high temperature, and therefore, is particularly useful as a die to be used for hot forming of a steel material.

The molding die of the present invention may include a CrN layer having a thickness of 3 to 10 μm as an intermediate layer between the above laminated hard film and the substrate, namely just on the substrate. This allows the excellent wear resistance and toughness to be exerted, while ensuring good adhesion between the laminated hard film and the substrate surface. The thickness of the intermediate layer in this case is preferably 3 μm or more, from the viewpoint of ensuring the adhesion. On the other hand, when the intermediate layer is excessively thick, the toughness of the whole film is deteriorated. Therefore, it is preferably 10 μm or less. More preferably, it is from 5 to 8 μm.

Although the kind of the substrate used in the above molding die is not particularly limited, examples thereof include tungsten-carbide-based cemented carbides such as WC-Co-based alloys, WC-TiC-Co-based alloys, WC-TiC-(TaC or NbC)-Co-based alloys and WC-(TaC or NbC)-Co-based alloys; cermet alloys such as TiC-Ni-Mo-based alloys and TiC-TiN-Ni-Mo-based alloys; high-speed tool steel materials such as SKH51 and SKD61 specified in JIS G 4403 (2006); alloy tool steel materials such as SKS 11 and SKD1 specified in JIS G 4404 (2006); and the like.

The hard film is formed on/above the substrate surface by using conventional methods such as a physical vapor deposition process (PVD process) and a chemical vapor deposition process (CVD process). Among these processes, the PVD process is preferably used to form the film, from the viewpoint of the adhesion of the hard film and the like. Specifically, there is a process of evaporating or ionizing a target used as a solid evaporation source and forming the film on/above the substrate in a gas atmosphere containing nitrogen or hydrocarbon.

As such a process, for example, an ion plating process such as an arc ion plating (AIP) process or a reactive PVD process such as a sputtering process is effective. Further, when the sputtering process is applied, unbalanced magnet sputtering (UBMS) having a large amount of ion irradiation to the substrate of the film to be formed is preferred.

Even when any of the film forming processes is adopted, the component composition of the target is preferably the same as the desired film composition, because the component composition of the target to be used determines the component composition of the film to be formed.

When the film is formed by the arc ion plating process, as the preferred conditions, examples thereof include, for example, the following conditions. When an iron-based material such as the tool steel material is used as the substrate, the substrate temperature during deposition is preferably 500°C or lower.

  Total Pressure: 0.5 Pa or more and 4 Pa or less
  Applied Current (Discharge Current): 100 to 200 A
  Substrate Temperature during Film Formation: 300°C or higher and 800°C or lower

The laminated hard film of the present invention is suitable for use in a molding die because of its excellent wear resistance and toughness. However, it can also be used, for example, as a hard film formed on/above a surface of a cutting tool by taking advantage of its properties.

EXAMPLES

The present invention is described more specifically below with reference to examples. However, it should be construed that the present invention is in no way limited by the following examples, and appropriate changes may be made without departing from the spirit and scope of the present invention described above and later. All of those are also included in the technical scope of the present invention.

Example 1

Monolayer or laminated films having compositions shown in the following

Table 1 were formed by an AIP system. At this time, targets corresponding to respective metal parts of layers A and layers B were used as targets. In addition, a fine particle WC-Co-based cemented carbide ball with a diameter of 10 mm, which had the same composition as a fine particle cemented carbide HTi 10 manufactured by Mitsubishi Materials Corporation was used, after a surface thereof was mirror-finished. As for test Nos. 1 to 31 in the following Table 1, CrN films having a thickness of 5 $\mu$m were formed as intermediate layers prior to the formation of the films. Further, as for test No. 32, the film was directly formed on a substrate surface without forming an intermediate layer.

[Table 1]

| Test No. | Layer A | | Layer B | | Number of Times of Laminating (times) |
|---|---|---|---|---|---|
| | Composition (Atomic Ratio) | Thickness (nm) | Composition (Atomic Ratio) | Thickness (nm) | |
| 1 | TiN | 5000 | - | - | - |
| 2 | CrN | 5000 | - | - | - |
| 3 | $(Ti_{0.5}Al_{0.5})N$ | 5000 | - | - | - |
| 4 | $(Al_{0.5}Cr_{0.5})N$ | 5000 | - | - | - |
| 5 | $(Al_{0.5}Cr_{0.5})N$ | 1 | CrN | 1 | 2500 |
| 6 | $(Al_{0.5}Cr_{0.5})N$ | 3 | CrN | 3 | 833 |
| 7 | $(Al_{0.5}Cr_{0.5})N$ | 10 | CrN | 10 | 250 |
| 8 | $(Al_{0.5}Cr_{0.5})N$ | 15 | CrN | 15 | 125 |

(continued)

| Test No. | Layer A Composition (Atomic Ratio) | Layer A Thickness (nm) | Layer B Composition (Atomic Ratio) | Layer B Thickness (nm) | Number of Times of Laminating (times) |
|---|---|---|---|---|---|
| 9 | $(Al_{0.5}Cr_{0.5})N$ | 30 | CrN | 30 | 83 |
| 10 | $(Al_{0.5}Cr_{0.5})N$ | 50 | CrN | 50 | 50 |
| 11 | $(Al_{0.5}Cr_{0.5})N$ | 100 | CrN | 100 | 25 |
| 12 | $(Al_{0.5}Cr_{0.5})N$ | 300 | CrN | 300 | 8 |
| 13 | $(Al_{0.3}Cr_{0.7})N$ | 10 | CrN | 10 | 250 |
| 14 | $(Al_{0.7}Cr_{0.3})N$ | 10 | CrN | 10 | 250 |
| 15 | $(Al_{0.9}Cr_{0.1})N$ | 10 | CrN | 10 | 250 |
| 16 | $(Al_{0.5}Cr_{0.5})(C_{0.1}N_{0.9})$ | 10 | $Cr(C_{0.1}N_{0.9})$ | 10 | 250 |
| 17 | AlN | 10 | CrN | 10 | 250 |
| 18 | $(Al_{0.5}Cr_{0.45}Si_{0.05})N$ | 10 | CrN | 10 | 250 |
| 19 | $(Al_{0.45}Cr_{0.45}Si_{0.1})N$ | 10 | CrN | 10 | 250 |
| 20 | $(Ti_{0.05}Al_{0.5}Cr_{0.45})N$ | 10 | CrN | 10 | 250 |
| 21 | $(Ti_{0.2}Al_{0.4}Cr_{0.4})N$ | 10 | CrN | 10 | 250 |
| 22 | $(Ti_{0.03}Al_{0.52}Cr_{0.4}Si_{0.05})N$ | 10 | CrN | 10 | 250 |
| 23 | $(Ti_{0.03}Al_{0.52}Cr_{0.4}Si_{0.05})N$ | 10 | $(Cr_{0.95}Si_{0.05})N$ | 10 | 250 |
| 24 | $(Ti_{0.03}Al_{0.52}Cr_{0.4}Si_{0.05})N$ | 10 | $(Al_{0.95}Si_{0.05})N$ | 10 | 250 |
| 25 | $(Al_{0.5}Cr_{0.5})N$ | 10 | $(Cr_{0.95}Si_{0.05})N$ | 10 | 250 |
| 26 | $(Al_{0.5}Cr_{0.5})N$ | 10 | $(Cr_{0.8}Si_{0.2})N$ | 10 | 250 |
| 27 | $(Ti_{0.03}Zr_{0.02}Al_{0.5}Cr_{0.45})N$ | 10 | CrN | 10 | 250 |
| 28 | $(Zr_{0.05}Al_{0.5}Cr_{0.45})N$ | 10 | CrN | 10 | 250 |
| 29 | $(Al_{0.5}Cr_{0.5})N$ | 10 | AlN | 10 | 250 |
| 30 | $(Al_{0.5}Cr_{0.5})N$ | 10 | $(Al_{0.95}Si_{0.05})N$ | 10 | 250 |
| 31 | $(Al_{0.5}Cr_{0.5})N$ | 10 | $(Al_{0.85}Si_{0.15})N$ | 10 | 250 |
| 32 | $(Al_{0.5}Cr_{0.5})N$ | 10 | CrN | 10 | 250 |

Specifically, the substrate as a body to be treated was heated to a temperature of 400°C by a heater mounted in a chamber of the above AIP system, and cleaning of the substrate surface by Ar ion was performed. The cleaning conditions were atmosphere: Ar, pressure: 0.6 Pa, voltage: 500 V and time: 5 min.

Thereafter, in a nitrogen atmosphere or an atmosphere of nitrogen+methane in the case of a C-containing film, the pressure in the chamber was adjusted to 4 Pa, and an arc discharge was started at a discharge current of 150 A to form a film having a total thickness of about 5 $\mu$m (about 5,000 nm) on the substrate. During the deposition, a bias voltage of 50 V was applied to the substrate so that the substrate has a minus potential to an earth potential.

When laminated hard films were formed as shown in test Nos. 5 to 32 in the above Table 1, the targets having compositions of the layers A and the layers B were attached to separate evaporation sources, respectively, and a table on which the substrate was mounted was rotated in the AIP system. First, only the target of the layers A was independently discharged in the nitrogen atmosphere or the nitrogen-methane atmosphere for a short period of time to form the layer A on a surface of the above intermediate layer or the substrate surface. Then, the target of the layers B was discharged, and thereafter, the table was rotated while concurrently discharging the layers A and the layers B, thereby forming a multilayer film.

In the above example, after the layer A was formed on the surface of the intermediate layer or the substrate surface, the layer B was formed. However, whichever of the layer A and the layer B may be present on the substrate side, there is slight difference in the properties therebetween.

The thickness of the layer A, the thickness of the layer B and the number of times of laminating in the multilayer film were adjusted by varying the rotation speed of the table. That is, when the rotation speed is increased, the thickness of the layer A and the thickness of the layer B are decreased, and the number of times of laminating is increased. When the rotation speed is decreased, the thickness of the layer A and the thickness of the layer B are increased, and the number of times of laminating is decreased. As shown in test Nos. 1 to 4 in Table 1 as comparative examples, various monolayer films were also formed in accordance with ordinary procedures.

As for the resulting cemented carbide balls coated with various films, a sliding test was performed under the following conditions to evaluate the wear resistance of the films. At this time, an alumina plate was used as the following plate in place of a steel plate having scales. The diameter of a worn part of the ball was measured, and the area corresponding to the diameter was evaluated as the wear amount. The case where the wear amount was 0.4 $\mu m^2$ or less was evaluated as excellent in the wear resistance.

Sliding Test Conditions

Test Method: ball-on-plate type reciprocating sliding
Ball: cemented carbide balls coated with various films
Plate: an alumina plate
Vertical Load: 5N
Sliding Speed: 0.1 m/sec
Sliding Amplitude: 30 mm
Sliding Distance: 72 m
Temperature: room temperature

Also, as for respective hard film coating members, a scratch test was performed under the following conditions to evaluate the toughness of the films. At this time, the critical load at which chipping occurred in the film was measured, while increasing the pressing load of an indenter from a load of 0 N to a load of 100 N at the following load increase rate. The case where the critical load measured value was 70 N or more was evaluated as excellent in the toughness.

Scratch Test Conditions

Indenter: a diamond indenter whose tip has a radius of curvature of 200 $\mu m$
Load Increase Rate: 100 N/min
Maximum Load: 100 N
Indenter Moving Speed: 10 mm/min
Temperature: room temperature

These evaluation results are shown in the following Table 2.

[Table 2]

| Test No. | Scratch Critical Load (N) | Wear Amount ($\mu m^2$) |
|---|---|---|
| 1 | 60 | 1.00 |
| 2 | 100 | 0.70 |
| 3 | 60 | 1.00 |
| 4 | 60 | 0.60 |
| 5 | 80 | 0.60 |
| 6 | 80 | 0.30 |
| 7 | 100 | 0.10 |
| 8 | 100 | 0.12 |

(continued)

| Test No. | Scratch Critical Load (N) | Wear Amount ($\mu m^2$) |
|---|---|---|
| 9 | 100 | 0.15 |
| 10 | 100 | 0.15 |
| 11 | 70 | 0.40 |
| 12 | 70 | 0.70 |
| 13 | 80 | 0.60 |
| 14 | 100 | 0.07 |
| 15 | 80 | 0.10 |
| 16 | 90 | 0.15 |
| 17 | 50 | 0.30 |
| 18 | 80 | 0.08 |
| 19 | 80 | 0.60 |
| 20 | 100 | 0.08 |
| 21 | 100 | 0.70 |
| 22 | 100 | 0.08 |
| 23 | 100 | 0.06 |
| 24 | 100 | 0.09 |
| 25 | 100 | 0.06 |
| 26 | 70 | 0.60 |
| 27 | 80 | 0.08 |
| 28 | 100 | 0.05 |
| 29 | 100 | 0.12 |
| 30 | 100 | 0.08 |
| 31 | 70 | 0.70 |
| 32 | 90 | 0.10 |

From these results, consideration can be made as follows. In test Nos. 6 to 11, 14 to 16, 18, 20, 22 to 25, 27 to 30 and 32, the compositions of the layers A and the layers B satisfy the range specified in the present invention. Therefore, it is found that good wear resistance and toughness are exerted.

In contrast, test Nos. 1 to 5, 12, 13, 17, 19, 21, 26 and 31 do not satisfy any one of the requirements specified in the present invention, and at least either of the wear resistance and the toughness is deteriorated. That is, test No. 1 is a conventional TiN monolayer film, and both the wear resistance and the toughness are deteriorated. Test No. 2 is a conventional CrN monolayer film, and the wear resistance is deteriorated.

Test Nos. 3 and 4 are examples of forming a monolayer type film formed of only the layer A, and both the wear resistance and the toughness are deteriorated. Test No. 5 is an example in which the layer A and the layer B are thin in thickness, and the wear resistance is deteriorated.

Test No. 12 is an example in which the layer A and the layer B are thick in thickness, and the wear resistance is deteriorated. Test No. 13 is an example in which the Al amount in the layers A is insufficient, and the wear resistance is deteriorated. Test No. 17 is an example in which the Al amount in the layers A is excessive, and the toughness is deteriorated. Test No. 19 is an example in which the Al amount in the layers A is insufficient and the Si amount is excessive, and the wear resistance is deteriorated.

Test No. 21 is an example in which the Ti amount in the layers A is excessive and the Al amount is insufficient, and the wear resistance is deteriorated. Test No. 26 is an example in which the Cr amount in the layers B is small and the Si amount is excessive, and the wear resistance is deteriorated. Test No. 31 is an example in which the Al amount in the layers B is small and the Si amount is excessive, and the wear resistance is deteriorated.

In this example, the sliding test and the scratch test were performed at room temperature to evaluate the wear resistance and the toughness of the films. However, it is considered that even when the temperature is increased, for example, to such a high temperature as about 400 to 500°C, the results are hardly influenced thereby. Therefore, the film of the present invention is excellent also in the properties at the above high temperature.

Example 2

Laminated films having compositions shown in the following Table 3 were formed in the same manner as in Example 1. In all examples of the following Table 3, CrN films having a thickness of 5 $\mu$m were formed as intermediate layers prior to the formation of the films. The film of No. 7 in Table 3 is the same as the film of No. 22 in Table 1. Further, the film of No. 10 in Table 3 is the same as the film of No. 27 in Table 1, the film of No. 12 in Table 3 is the same as the film of No. 28 in Table 1, the film of No. 14 in Table 3 is the same as the film of No. 25 in Table 1, and the film of No. 16 in Table 3 is the same as the film of No. 30 in Table 1.

The total Al atomic ratios of the resulting various films were determined from the compositions of the respective layers, lattice constants shown in Table 3 and thicknesses of the respective layers by the method described above. The total Al atomic ratios are shown in Table 3. In addition, as for the resulting cemented carbide balls coated with various films, the sliding test was performed in the same manner as in Example 1 to evaluate the wear resistance of the films. Furthermore, as for respective hard film coating members, the scratch test was performed in the same manner as in Example 1 to evaluate the toughness of the films. These results are shown in Table 4.

[Table 3]

| Test No. | Layer A | | | Layer B | | | Total Al Atomic Ratio | Number of Times of Laminating (times) |
|---|---|---|---|---|---|---|---|---|
| | Composition (Atomic Ratio) | Lattice Constant (nm) | Layer Thickness (mn) | Composition (Atomic Ratio) | Lattice Constant (nm) | Layer Thickness (nm) | | |
| 1 | $(Al_{0.7}Cr_{0.3})N$ | 0.4126 | 20 | CrN | 0.414 | 5 | 0.56 | 200 |
| 2 | $(Al_{0.7}Cr_{0.3})N$ | 0.4126 | 20 | CrN | 0.414 | 10 | 0.47 | 167 |
| 3 | $(Al_{0.7}Cr_{0.3})N$ | 0.4126 | 20 | CrN | 0.414 | 20 | 0.35 | 125 |
| 4 | $(Al_{0.7}Cr_{0.3})N$ | 0.4126 | 20 | CrN | 0.414 | 40 | 0.23 | 83 |
| 5 | $(Al_{0.5}Cr_{0.5})N$ | 0.413 | 20 | CrN | 0.414 | 10 | 0.33 | 167 |
| 6 | $(Al_{0.5}Cr_{0.5})N$ | 0.413 | 10 | CrN | 0.414 | 5 | 0.33 | 333 |
| 7 | $(Ti_{0.03}Al_{0.52}Cr_{0.40}Si_{0.05})N$ | 0.43386 | 10 | CrN | 0.414 | 10 | 0.24 | 250 |
| 8 | $(Ti_{0.03}Al_{0.52}Cr_{0.40}Si_{0.05})N$ | 0.43386 | 10 | CrN | 0.414 | 5 | 0.33 | 333 |
| 9 | $(Ti_{0.03}Al_{0.52}Cr_{0.40}Si_{0.05})N$ | 0.43386 | 20 | CrN | 0.414 | 5 | 0.40 | 200 |
| 10 | $(Ti_{0.03}Zr_{0.02}Al_{0.5}Cr_{0.45})N$ | 0.41416 | 10 | CrN | 0.414 | 10 | 0.25 | 250 |
| 11 | $(Ti_{0.03}Zr_{0.02}Al_{0.5}Cr_{0.45})N$ | 0.41416 | 20 | CrN | 0.414 | 10 | 0.33 | 167 |
| 12 | $(Zr_{0.05}Al_{0.5}Cr_{0.45})N$ | 0.41515 | 10 | CrN | 0.414 | 10 | 0.25 | 250 |
| 13 | $(Zr_{0.05}Al_{0.5}Cr_{0.45})N$ | 0.41515 | 20 | CrN | 0.414 | 5 | 0.40 | 200 |
| 14 | $(Al_{0.5}Cr_{0.5})N$ | 0.413 | 10 | $(Cr_{0.95}Si_{0.05})N$ | 0.414 | 10 | 0:25 | 250 |
| 15 | $(Al_{0.5}Cr_{0.5})N$ | 0.413 | 20 | $(Cr_{0.9}Si_{0.1})N$ | 0.414 | 10 | 0.33 | 167 |
| 16 | $(Al_{0.5}Cr_{0.5})N$ | 0.413 | 10 | $(Al_{0.95}Si_{0.05})N$ | 0.412 | 10 | 0.25 | 250 |
| 17 | $(Al_{0.5}Cr_{0.5})N$ | 0.413 | 10 | $(Al_{0.95}Si_{0.05})N$ | 0.412 | 5 | 0.33 | 333 |

[Table 4]

| Test No. | Scratch Critical Load (N) | Wear Amount ($\mu m^2$) |
|---|---|---|
| 1 | 90 | 0.15 |
| 2 | 100 | 0.05 |
| 3 | 100 | 0.04 |
| 4 | 80 | 0.2 |
| 5 | 90 | 0.05 |
| 6 | 90 | 0.05 |
| 7 | 100 | 0.08 |
| 8 | 100 | 0.05 |
| 9 | 100 | 0.04 |
| 10 | 80 | 0.12 |
| 11 | 80 | 0.06 |
| 12 | 100 | 0.13 |
| 13 | 100 | 0.05 |
| 14 | 100 | 0.14 |
| 15 | 100 | 0.04 |
| 16 | 100 | 0.08 |
| 17 | 100 | 0.05 |

From the results of Table 3 and Table 4, consideration can be made as follows. As for all of Nos. 1 to 17 in Table 3, the rations of the elements in each layer of the layers A and the layers B are within the specified ranges, and the total Al atomic ratio is within the preferred range. As a result, it is found that good wear resistance and toughness are exerted. The total Al atomic ratio is within the preferred range as described above, so that it is found that the wear amount is 0.20 $\mu m^2$ or less, which shows good toughness. In particular, it is found that in the examples in which the total Al atomic ratio is within the range of 0.35 to 0.55, a wear amount of 0.10 $\mu m^2$ or less can be achieved to show sufficiently excellent toughness.

Although the present invention has been described in detail with reference to the specific embodiments, it will be apparent to those skilled in the art that various variations and modifications can be made without departing from the spirit and scope of the present invention.

The present application is based on Japanese Patent Application No. 2014-193885 filed on September 24, 2014 and Japanese Patent Application No. 2014-266487 filed on December 26, 2014, the contents of which are incorporated herein by reference.

INDUSTRIAL APPLICABILITY

A laminated hard film of the present invention is more enhanced in wear resistance and toughness, and is useful for a jig and tool or a molding die having an cemented carbide, a cermet, a high-speed tool steel, an alloy tool steel or the like as a substrate.

Claims

1.   A laminated hard film obtained by laminating a layer A and a layer B, the layer A having a composition different from that of the layer B, wherein
the layer A is formed of $(Ti_aCr_bAl_cSi_d)(C_xN_{1-x})$ and satisfies the relationship of $0 \leq a \leq 0.10$, $0.10 \leq b \leq 0.50$, $0.50 \leq c \leq 0.90$, $0 \leq d \leq 0.05$, $a+b+c+d=1$ and $0 \leq x \leq 0.5$, when atomic ratios of Ti, Cr, Al, Si and C are defined as a, b, c, d and x, respectively,

the layer B is formed of $(Cr_eSi_{1-e})(C_yN_{1-y})$ and satisfies the relationship of $0.90 \leq e \leq 1.0$ and $0 \leq y \leq 0.5$, when atomic ratios of Cr and C are defined as e and y, respectively, or is formed of $(Al_fSi_{1-f})(C_zN_{1-z})$ and satisfies the relationship of $0.90 \leq f \leq 1.0$ and $0 \leq z \leq 0.5$, when atomic ratios of Al and C are defined as f and z, respectively, and each of the layer A and the layer B has a thickness of 2 to 100 nm, and the layer A and the layer B are each alternately laminated.

2. The laminated hard film according to claim 1, wherein the atomic ratio of Al to a total of Ti, Cr, Al and Si in the layer A and the layer B falls within a range of 0.20 to 0.60.

3. The laminated hard film according to claim 1 or 2, wherein Ti in the layer A is at least partially substituted with Zr.

4. A molding die comprising the laminated hard film according to claim 1 or 2 on/above a substrate surface.

5. A molding die comprising the laminated hard film according to claim 3 on/above a substrate surface.

6. The molding die according to claim 4, comprising an intermediate layer of CrN having a thickness of 3 to 10 $\mu$m between the laminated hard film and the substrate.

7. The molding die according to claim 5, comprising an intermediate layer of CrN having a thickness of 3 to 10 $\mu$m between the laminated hard film and the substrate.

8. The molding die according to claim 6, which is used for hot forming of a steel material.

9. The molding die according to claim 7, which is used for hot forming of a steel material.

## INTERNATIONAL SEARCH REPORT

| International application No. |
|---|
| PCT/JP2015/076204 |

A.  CLASSIFICATION OF SUBJECT MATTER
*C23C14/06*(2006.01)i, *B21D37/01*(2006.01)i, *B21D37/20*(2006.01)i

According to International Patent Classification (IPC) or to both national classification and IPC

B.  FIELDS SEARCHED

Minimum documentation searched (classification system followed by classification symbols)
C23C14/06, B21D37/01, B21D37/20

Documentation searched other than minimum documentation to the extent that such documents are included in the fields searched
Jitsuyo Shinan Koho          1922–1996   Jitsuyo Shinan Toroku Koho   1996–2015
Kokai Jitsuyo Shinan Koho    1971–2015   Toroku Jitsuyo Shinan Koho   1994–2015

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| X<br>A | JP 2007-111815 A  (Sumitomo Electric Hardmetal Corp.),<br>10 May 2007 (10.05.2007),<br>claims; paragraph [0015]; examples<br>(Family: none) | 1-3<br>4-9 |
| X<br>A | JP 2010-115739 A  (Sumitomo Electric Hardmetal Corp.),<br>27 May 2010 (27.05.2010),<br>claims; examples<br>(Family: none) | 1-2<br>3-9 |

[X] Further documents are listed in the continuation of Box C.        [ ] See patent family annex.

| * | Special categories of cited documents: |
|---|---|
| "A" | document defining the general state of the art which is not considered   to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search<br>17 December 2015 (17.12.15) | Date of mailing of the international search report<br>28 December 2015 (28.12.15) |
|---|---|
| Name and mailing address of the ISA/<br>Japan Patent Office<br>3-4-3,Kasumigaseki,Chiyoda-ku,<br>Tokyo 100-8915,Japan | Authorized officer<br><br>Telephone No. |

Form PCT/ISA/210 (second sheet) (July 2009)

## INTERNATIONAL SEARCH REPORT

International application No.

PCT/JP2015/076204

C (Continuation).    DOCUMENTS CONSIDERED TO BE RELEVANT

| Category* | Citation of document, with indication, where appropriate, of the relevant passages | Relevant to claim No. |
|---|---|---|
| X<br>A | WO 2007/083361 A1  (Mitsubishi Heavy Industries, Ltd.),<br>26 July 2007 (26.07.2007),<br>example 9<br>& US 2009/0123737 A1<br>table 1; example 9 | 1-2<br>3-9 |

Form PCT/ISA/210 (continuation of second sheet) (July 2009)

## REFERENCES CITED IN THE DESCRIPTION

**Patent documents cited in the description**

- JP 4668214 B
- JP 2014 A
- JP 193885 A
- JP 2014266487 A